# EUROPÄISCHE PATENTANMELDUNG

(11) **EP 0 964 606 A2**
(43) Veröffentlichungstag der Anmeldung: **15.12.1999**
(21) Anmeldenummer: 99102987.7
(22) Anmeldetag: 15.02.1999
(51) Int. Cl.: H05K 1/14, H05K 3/36

(54) **Kontaktierung zwischen wenigstens zwei Leiterplatten**

(30) Priorität: 09.06.1998 DE 19825666
(71) Anmelder: ROBERT BOSCH GMBH, 70442 Stuttgart (DE)
(72) Erfinder: Sabotke, Jens, 31139 Hildesheim (DE); Hauschild, Frank-Dieter, 31135 Hildesheim (DE); Stille, Ulrich, 31199 Diekholzen (DE)

(57) **Zusammenfassung**

Eine Kontaktierung zwischen wenigstens zwei Leiterplatten, insbesondere zwischen einer mit Displaytreibern und/oder anderen Bauelementen bestückten Leiterplatte und einer mit einem Display bestückten Leiterplatte, ist dadurch gekennzeichnet, daß wenigstens zwei Leitfolien die mit Kontaktelementen der einen Leiterplatte elektrisch leitend verbunden, von dort auf beide Seiten der anderen Leiterplatte geführt und mit dort angeordneten Kontaktelementen auf der anderen Leiterplatte elektrisch leitend verbunden sind.

## Beschreibung

### Stand der Technik

Die Erfindung betrifft eine Kontaktierung zwischen wenigstens zwei Leiterplatten, insbesondere zwischen einer Leiterplatte mit einem Displaytreiber und einer Leiterplatte mit einem Display.

Aus der DE 94 21 742 U1 geht die Kontaktierung zwischen zwei Leiterplatten durch eine Leitfolie hervor.

Problematisch bei einer solchen Kontaktierung ist es, daß insbesondere bei zweiseitig bestückten Leiterplatten eine sehr hohe Dichte von Anschlußelementen auf der Leiterplatte und in Folge davon eine sehr hohe Dichte von Anschlußelementen in der Leitfolie vorgesehen sein muß.

Der Erfindung liegt daher die Aufgabe zugrunde, eine Kontaktierung zwischen wenigstens zwei Leiterplatten der gattungsgemäßen Art derart weiterzubilden, daß durch Leitfolien eine möglichst große Anzahl von Kontaktelementen elektrisch leitend verbindbar sind.

Diese Aufgabe wird erfindungsgemäß bei einer Kontaktierung zwischen wenigstens zwei Leiterplatten der eingangs beschriebenen Art gelöst durch wenigstens zwei Leitfolien, die mit Kontaktelementen der einen Leiterplatte elektrisch leitend verbunden, von dort auf beide Seiten der anderen Leiterplatte geführt und mit dort angeordneten Kontaktelementen der anderen Leiterplatte elektrisch leitend verbunden sind.

Durch die beiden Leitfolien, die einseitig auf einer und zweiseitig auf der anderen Leiterplatte angeschlossen sind, wird auf besonders vorteilhafte Weise ein größeres Anschlußraster ermöglicht. Darüber hinaus kann auf diese Weise eine der beiden Leiterplatten zweiseitig bestückt werden, wodurch sich eine Flächenreduktion ergibt.

Die Leitfolien können praktisch an einer beliebigen Stelle der Leiterplatten angeschlossen werden. Eine vorteilhafte Ausführungsform sieht vor, daß die Leitfolien wenigstens teilweise über den auf der zweiten Leiterplatte angeordneten Bauteilen verlaufen.

### Zeichnung

Weitere Vorteile und Merkmale der Erfindung sind Gegenstand der nachfolgenden Beschreibung sowie der zeichnerischen Darstellung einiger Ausführungsbeispiele.

### Beschreibung der Ausführungsbeispiele

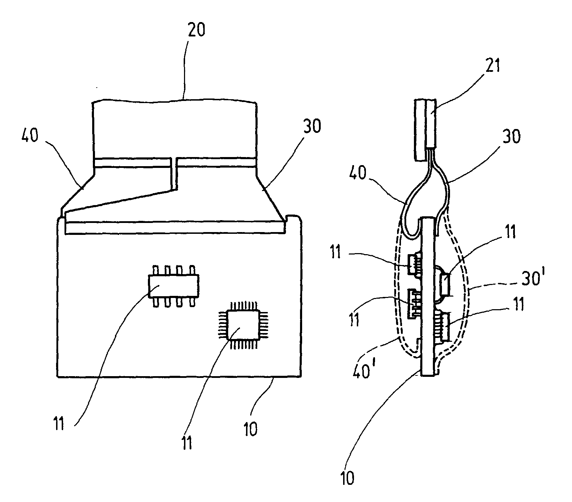

Zur Kontaktierung einer Leiterplatte 20, die beispielsweise wie in der Figur dargestellt, mit einem Display 21 versehen ist, mit einer weiteren Leiterplatte 10, die beispielsweise mit Displaytreibern und sonstigen Bauelementen 11 versehen ist, sind Leitfolien 30, 40 vorgesehen. Die Leitfolien 30, 40 sind auf einer Seite der mit dem Display 21 bestückten Leiterplatte 20 mit auf dieser Leiterplatte 20 angeordneten (nicht dargestellten) Kontaktelementen kontaktiert. Sie sind von dort auf beide Seiten der Leiterplatte 10 geführt und mit (nicht dargestellten) Kontaktelementen, die auf dieser Leiterplatte 10 angeordnet sind, elektrisch leitend verbunden. Eine der beiden Leitfolien 40 ist dabei S-förmig zwischen den beiden Leiterplatten 10, 20 angeordnet, wodurch auf einfache Weise eine Kontaktierung der nur auf einer Seite der Leitfolie angeordneten Kontaktbahnen ermöglicht wird.

Wie aus der Figur ferner hervorgeht, können bei einer anderen Ausführungsform die Leitfolien 30', 40' auch über den auf der weiteren Leiterplatte 10 angeordneten Bauelementen 11 verlaufen, wodurch eine Anbindung der Leitfolien 30', 40' praktisch an jeder Stelle der Leiterplatten 10 möglich ist.

## Patentansprüche

1. Kontaktierung zwischen wenigstens zwei Leiterplatten (10, 20), insbesondere zwischen einer mit Displaytreibern und/oder anderen Bauelementen bestückten Leiterplatte (10) und einer mit einem Display (21) bestückten Leiterplatte (20), gekennzeichnet durch wenigstens zwei Leitfolien (30, 40; 30', 40'), die mit Kontaktelementen der einen Leiterplatte (20) elektrisch leitend verbunden, von dort auf beide Seiten der anderen Leiterplatte (10) geführt und mit dort angeordneten Kontaktelementen auf der anderen Leiterplatte (10) elektrisch leitend verbunden sind.

2. Kontaktierung nach Anspruch 1, dadurch gekennzeichnet, daß die Folie wenigstens teilweise über den auf der weiteren Leiterplatte (10) angeordneten Bauteilen verläuft.
